**Europäisches Patentamt**

**European Patent Office**

**Office européen des brevets**

(19)

(11) **EP 1 538 752 A1**

(12) **EUROPEAN PATENT APPLICATION**

(43) Date of publication:
08.06.2005 Bulletin 2005/23

(51) Int Cl.⁷: **H03K 5/13**

(21) Application number: 03292967.1

(22) Date of filing: 28.11.2003

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK**<br><br>(71) Applicant: **Freescale Semiconductor, Inc.**<br>**Austin, Texas 78735 (US)** | (72) Inventor: **Ihs, Hassan**<br>**31100 Toulouse (FR)**<br><br>(74) Representative: **Wharmby, Martin Angus**<br>**Freescale Semiconductor Inc.**<br>**c/o Impetus IP Limited**<br>**Grove House**<br>**Lutyens Close**<br>**Basingstoke, Hampshire RG24 8AG (GB)** |

(54) **Clock pulse generator apparatus with reduced jitter clock phase**

(57) Clock pulse generator apparatus comprising a clock pulse generator (CLK) for generating a train of primary clock pulses having leading and trailing edges. A delay line (14) produces a train of delayed clock pulses (CLK_D) presenting delayed edges whose timing relative to corresponding edges of the primary clock pulses (CLK) is defined by the delay line. A logic circuit (15) produces a train of combined clock pulses (CLK_JF) presenting leading and trailing edges defined alternately by one of the delayed edges and the corresponding edge of the primary clock pulse, so that the combined clock pulses comprise active clock phases (ACP) having widths defined by the delay line; the variability of the widths of the active clock phases (ACP) is smaller than the variability of the positions of the leading and trailing edges of the primary clock pulses (CLK). The active clock phases (ACP) alternate with non-active clock phases (NACP) whose widths vary as a function of variation in the positions of the primary clock pulses (CLK) and absord those variations. The delay line (14) comprises a series of cascaded, substantially identical delay elements (16). A temperature and process variation circuit (22) is also described.

Application especially to continuous-time sigma-delta converters where a critical integrator (2; 10) integrates a signal over periods of time defined by the widths of the active clock phases (ACP).

FIG. 6

FIG. 8

**Description**

Field of the invention

This invention relates to clock pulse generator apparatus and especially, but not exclusively, to apparatus for converting between analogue and digital signals comprising continuous-time sigma-delta conversion means and clock pulse generator apparatus.

Background of the invention

Continuous Time ('CT') Sigma Delta converters, both analogue-to-digital ('ADC') and digital-to-analogue ('DAC'), are considered to be a particularly appropriate type of converter for high signal bandwidth, high resolution and low power applications; converters of this kind are described, for example in "Continuous-time sigma-delta modulation for A/D conversion in radio receivers", L. Breems and J. Huijsing, Kluwer Academic Publishers, ISBN 0-7923-7492-4. Indeed, CT sigma delta modulators have Factors Of Merit (FOM) from five to ten times better than their Discrete Time (DT) counterpart, and even better when compared to other Nyquist rate converters. The FOM indicates the amount of power needed to convert to digital one signal LSB and thus reflects the power consumption of the converter for a given number of bits. CT modulators also have the merit of not aliasing noise in contrast to DT modulators. This feature is very important especially in System On Chip (SOC) integrated circuits ('IC's) where multi-disciplinary cores are integrated on the same die.
Continuous Time sigma delta modulation is also widely used in Voice/Audio DACs (see "A 113-dB SNR oversampling DAC with segmented noise-shaped scrambling Adams, R."; Nguyen, K.Q.; Solid-State Circuits, IEEE Journal of, Volume: 33 Issue: 12, Dec 1998, Pages 1871 -1878), as well as in intermediate frequency ('IF') ADCs of wireless communications (see "A 1.8-mW CMOS Sigma Delta modulator with integrated mixer for A/D conversion of IF signals", Breems, L.J.; van der Zwan, E.J.; Huijsing, J.H.; Solid-State Circuits, IEEE Journal of, Volume: 35 Issue: 4, Apr 2000, pages: 468 -475). In all these applications, a very low jitter sampling clock is required which is generally very difficult to obtain without the use of a high performance (high cost) phase-locked loop ('PLL') device. Jitter is a random error in the time position of the pulse edges.
Another aspect of the utility of CT converters is where MHz-range bandwidth analogue IF signals are to be converted to digital preventing thus the use of traditional switched capacitor ADCs. There is no doubt that CT sigma deltas are very efficient ADC/DACs for such high speed and low power applications; nevertheless, their sensitivity to clock jitter currently limits their maximal achievable dynamic ranges. In contrast to discrete time modulators where the sampling time accuracy does not matter as long as full settling of the signal is attained within one clock period, known CT modulators integrate the signal over a period defined by the clock pulse (half period in return-to-zero 'RTZ' modulators) making the timing errors appear as voltage noise. Modern SOCs exhibit particularly large clock jitter due to high switching activities of the integrated digital cores and consequently add more limitation to the achievable dynamic range of CT modulators.
Attempts have been made to make CT modulators resistant to jitter: see "Implementation of a 1.5V low-power clock-jitter insensitive continuous-time Sigma Delta modulator", Gerfers, F.; Ortmanns, M.; Samid, L.; Manoli, Y.; Circuits and Systems, 2002. ISCAS 2002. IEEE International Symposium on, Volume: 2, 2002, pages 652 -655, and "Method and apparatus for eliminating clock jitter in continuous time delta sigma analog to digital converters", US patent US6184812B1, issued on Feb. 6, 2001, for example. However, these techniques are intrusive to the circuit in the sense that they limit its maximum speed and add new parasitics to the signal.
There is a need for analogue/digital converters, especially of the kind including CT-sigma-delta modulators, and also other circuits, that function with little or no sensitivity to clock pulse jitter. Seen differently, there is a need for a clock pulse generator that enables associated circuits to function with little or no sensitivity to clock pulse jitter: such a generator is applicable to analogue/digital converters and also to other circuits that would otherwise be susceptible to clock jitter.

Summary of the invention

The present invention provides a clock pulse generator apparatus and apparatus for converting between analogue and digital signals comprising continuous-time sigma-delta conversion means and clock pulse generator apparatusas described in the accompanying claims.
The present invention is particularly, but not exclusively, usable in conjunction with the invention of our co-pending European patent application N° EP 02292758.6 of 6th November 2002, relating to a converter, circuit and method for compensation of non-idealities in continuous time sigma delta converters. This co-pending application specifically offers solutions to problems associated with feedback path non-idealities, especially in CT sigma delta modulators and converters, and specifically asymmetric rising/falling edges.

Brief description of the drawings

Figure 1 is a block schematic diagram of a continuous-time Analogue-to-Digital sigma-delta modulator to which the present invention may be applied,

Figure 2 is a block schematic diagram of a continuous-time Digital-to-Analogue sigma-delta modulator to which the present invention may be applied,

Figure 3 is a timing diagram of return-to-zero and non-return-to-zero clock pulses,

Figure 4 is a timing diagram illustrating the effect of jitter on clock pulse positions,

Figure 5 is a block schematic diagram of a clock pulse generator in accordance with one embodiment of the invention, given by way of example,

Figure 6 is a timing diagram of clock pulses in the generator of Figure 5,

Figure 7 is a simplified circuit diagram of delay elements in the generator of Figure 5,

Figure 8 is a circuit diagram of a delay module in the generator of Figure 5 comprising delay elements of the kind illustrated in Figure 7, and

Figure 9 is a circuit diagram of another delay module in the generator of Figure 5 comprising delay elements of the kind illustrated in Figure 7.

Detailed description of the preferred embodiments

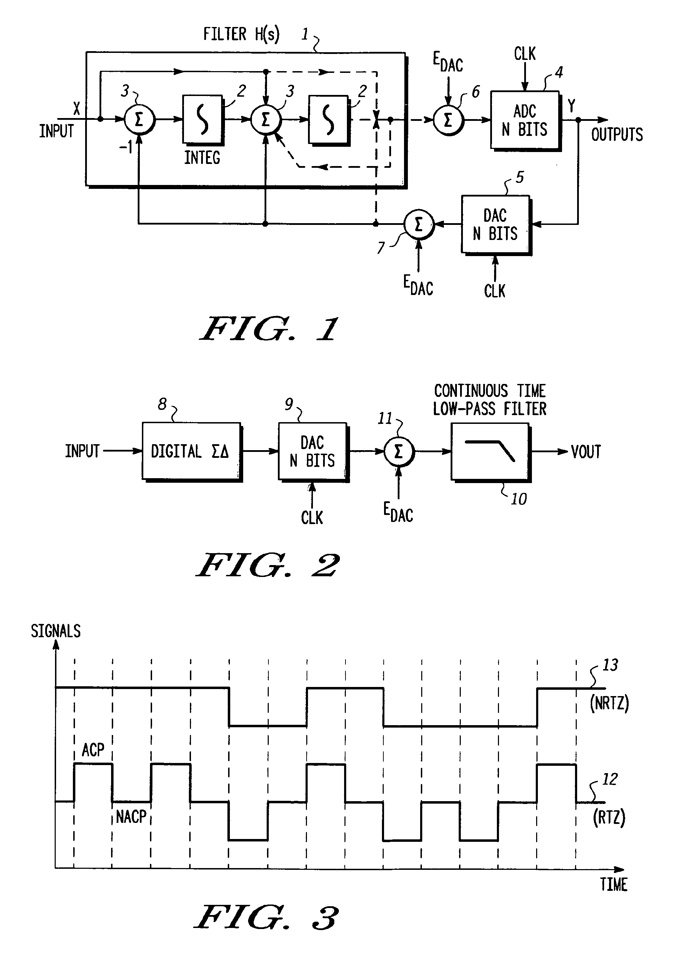

Figure 1 shows the general scheme of a CT sigma delta modulator incorporated in an analog to digital sigma delta modulator. It is constituted of a loop filter 1 having a transfer function H and comprising a series of integrators 2 and summers 3, an n bits ADC 4 and a feedback loop comprising an n bits DAC 5. Two error components associated with non-idealities are shown as signals added into the forward (*Eadc*) and the feedback (*Edac*) paths by notional adders 6 and 7. The continuous time characteristic of this modulator resides in the fact that the loop filter characteristic H(s) is Continuous Time (active-RC or Gm-C based).
The modulator of Figure 1 is characterized by Equation 1 that expresses the modulator's output Y as a function of the input X, the filter function H and the error components *Eadc* and *Edac*:

$$Y(z) = X(z)\ \frac{H(z)}{1+ H(z)} + E_{dac}(z)\ \frac{H(z)}{1 + H(z)} ++ E_{adc}(z)\ \frac{1}{1 + H(z)} \qquad \text{Equation 1}$$

*H(z)* stands for the *z*-transform of the filter. The function *H/(1+H)* is a low-pass filter having a DC gain of 1 while *1/(1+H)* is a high-pass filter with ideally an infinite DC attenuation. Thus, the non idealities of the forward path are high-pass filtered (noise-shaped) while the feedback path non-idealities are untouched and remain present in the signal base band. Equation 1 shows clearly that the feedback path non-ideality errors $E_{dac}$ 7 are present in the signal base band.
Jitter timing errors affect the feedback DAC 5 and lead to voltage integration errors. These timing errors can clearly be modeled as voltage errors *Edac* 7 at the output of the DAC 5 in the feedback loop. The jitter power is thus directly transferred to the output without any noise-shaping.
Figure 2 shows the general scheme of a continuous time Digital to Analog Converter comprising a digital sigma delta modulator 8, a DAC 9 and a low pass filter 10.
In a similar manner to the analog to digital sigma delta modulator of Figure 1, timing errors of the DAC 9 due to clock jitter in the Digital to Analog Converter are integrated by the low pass filter 10 and appear as voltage errors *Edac* 10 at the output of the filter, again being represented by a notional adder 11. In this converter as well, the Continuous Time characteristics resides in the fact that the low-pass filter is continuous time.
Another DAC non-ideality that affects CT sigma delta is the sampling clock unmatched rising and falling edges.

This error creates differences between the durations of the positive and negative levels. This in turn leads to DC and even harmonic distortion of the signal. To prevent this non-ideality from affecting the modulators, a technique called Return-To Zero ('RTZ') signaling is widely used especially in high speed and high performances sigma deltas. A technique of this kind is described in US patent specification 5 196 853, for example. It consists of returning to zero for half of each clock cycle the levels of the modulator's DAC as illustrated in Figure 3 at 12. This method is widely used in Data Communications where such a signal coding results in reduced Inter-symbol Interference. Return to Zero operation makes all the DAC signal levels systematically sensitive to asymmetric rising and falling edges. This leads to a DC component error only, which it is easy to digitally high pass filter downstream. In Non-Return-To-Zero operation, as at 13, the signal does not return to zero at each half clock cycle, these non idealities affect only signal levels that are adjacent to the transitions and the error due to asymmetric rising and falling transitions appear as even harmonic distortions. Figure 3 shows both RTZ and NRTZ signals. As indicated in the drawing, there are active phases where the RTZ signal is at either high or low levels and there are inactive phases where the signal simply goes to zero.

The jitter reduction technique presented in this paper is applicable to RTZ CT sigma deltas and is described primarily with reference to RTZ operation, which is the most widely used.

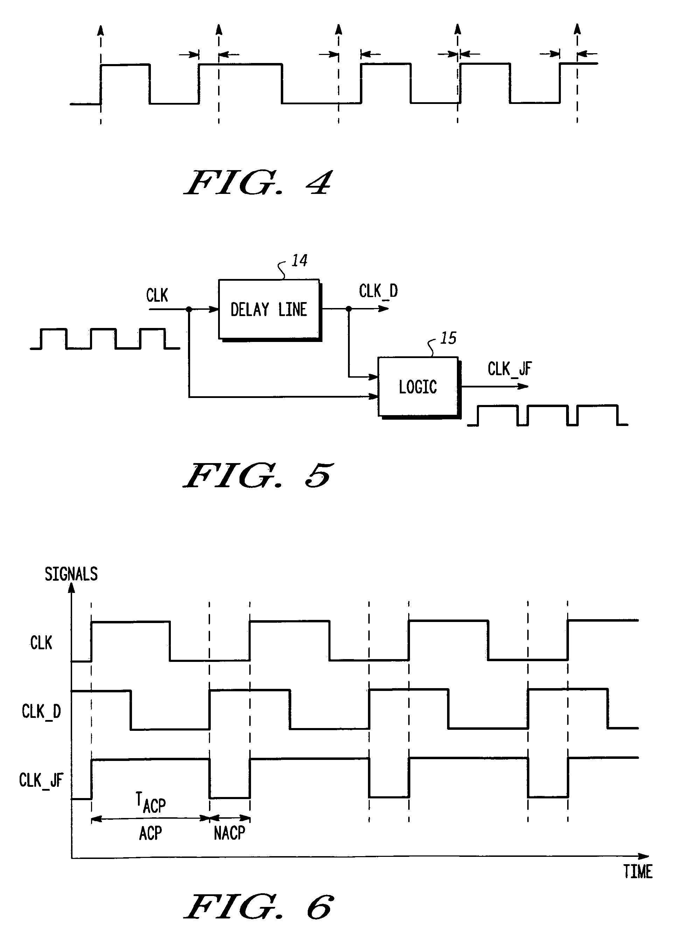

Clock signals suffer from time displacements of the transition edges due to noise in the circuits they are travelling through (see Figure 4), these time displacements of the clock edges being the jitter referred to above. Jitter is due to all kinds of noise sources such as thermal, flicker, power supply and substrate noise that affects electronic devices. Jitter may originate from the clock reference (crystal oscillator), from the multiplying PLL, from the clock recovery circuits as well as from the digital circuitry that the clock signal travels across. As jitter is a timing translation of noise, it may be random or deterministic depending on the nature of noise source.

There are mainly three types of jitter:

- Phase jitter, which is also called long term jitter: it corresponds to clock edge deviations with respect to ideal clock edges. This type of jitter affects mostly data recovery systems where it may lead to bit errors.
- Period jitter: It corresponds to the deviations of the clock periods with respect to an ideal clock period. CT sigma delta data converters are very sensitive to this jitter type more than any other jitter type.
- Cycle to Cycle jitter: It corresponds to differences between pairs of adjacent clock cycles.

These three types of jitter are related. In fact, the period jitter corresponds to the first order derivative of the phase jitter while the cycle to cycle jitter corresponds to the second order derivative of the phase jitter.

Continuous time sigma delta modulation suffers from two jitter effects. The first effect that all data converters suffer from, whether they are continuous time or discrete time converters, is the time uncertainty in sampling the input signal. It has been proven that this effect of jitter is insignificant especially in high over-sampling rate ('OSR') modulators. The second effect affects only Continuous Time sigma deltas due to their nature of being sensitive to feedback path waveform. It is by far the more important jitter effect for CT sigma deltas. In fact, as the first stage of digital to analog CT sigma delta modulators is a continuous time integrator (for example, the low pass filter of a digital to analog CT sigma delta), any timing error in the sampling clock will translate into voltage error at the output of the integrator. This in turn leads to increase in the noise floor and to Signal to Noise Ratio (SNR) degradation. Noise power due to jitter falls down into the converter base band using two mechanisms. The first one is due to low frequency jitter content that lies in the base band. The second is due to high frequency jitter content that gets folded back to the base band by mixing down with the quantization noise. The latter mechanism can be reduced by increasing the number of quantization levels in the modulator quantizer.

An audio DAC has been simulated with clock jitter of 300ps, a jitter value that is typically measured on clocks of large digital core mixed-signal ICs. The DAC comprises a second order 5-level sigma delta modulator driving a second order active-RC low pass-filter and is sampled at 6.5Mhz clock rate. The SNR dropped from ideal 97dB to 72dB corresponding thus to 25dB loss in the SNR. In fact, the noise floor level of the jittery signal is 30dB higher than the jitter-free signal.

Unlike the prior art techniques, this embodiment of the present invention avoids interfering with the normal operation of the circuit but rather focuses on attenuating jitter within the clock signal before it is applied to the circuit. In other words, this embodiment of the invention is based on attenuating clock jitter effects rather than modifying the circuit topology to achieve lower jitter sensitivity.

One way to attenuate jitter would be to pass the jittery clock through a phase-locked loop ('PLL') whose phase transfer function cuts off early enough to suppress most of the clock jitter power. Although such a technique is non-intrusive, it requires an entire analog module (PLL) that is not straightforward to design. It also consumes significant power and occupies a large silicon area as it requires external passive devices (PLL filter). It would accordingly be an expensive solution.

As depicted in Figure 3, RTZ signal has an active clock phase ('ACP') and a non-active clock phase ('NACP'), the expression active referring to the activity of the application that the clock signal pilots. This embodiment of the present invention makes the width of the ACP relatively jitter-free while allowing most of the jitter to be absorbed by the NACP. Thus, jitter affects the non active phase and its power does not add to the signal power. This is achieved with a clock generator using a local time reference built using a delay line 14 and a logic AND/NAND circuit 15, as shown in Figure 5.

The clock generator works as following. The jittery clock input signal CLK from a suitable source is delayed using the delay line 14; in an example of this embodiment of the invention, the delay line 14 introduces a delay adjusted to two thirds (2/3) of the clock period. Both the clock and the delayed clock (CLK_D) signals are applied as inputs to the logic AND/NAND circuit 15, whose output CLK_JF is asserted at the leading edge of the CLK signals and is de-asserted at the leading edge of the CLK_D signals. The timing diagram of the clock generator is shown in Figure 6. In this embodiment of the present invention, the width of ACP is entirely determined by the delay in the delay line rather than the clock half period in traditional RTZ technique. In fact, jitter causes the whole ACP phase to move left or right while its width is always kept unaffected. However, the NACP width expands and shrinks according to jitter deviations and absorbs all the jitter in order to preserve the ACP.

As the delay-line delay completely determines the ACP duration $T_{ACP}$, it needs to be designed in such a way it is insensitive to noise (thermal, flicker, substrate and power supply noise). It is possible to implement the delay line using differential circuitry in order to reduce certain categories of noise such as substrate and power-supply noise, for example. The choice of 2/3 of the clock period as delay in the delay line leaves the larger part of the clock cycle to the active phase ACP while still leaving the non-active phase NACP enough time to safely achieve return to zero. It should be noted that the larger ACP duration, the better the sensitivity to pulse transition errors such as spikes and slow transitions as well as to any residual jitter that may leak through the attenuator.

In a typical application to a sigma delta module, the active phase ACP is preferably used as the phase where the integration is performed while the NACP is used for returning to zero.

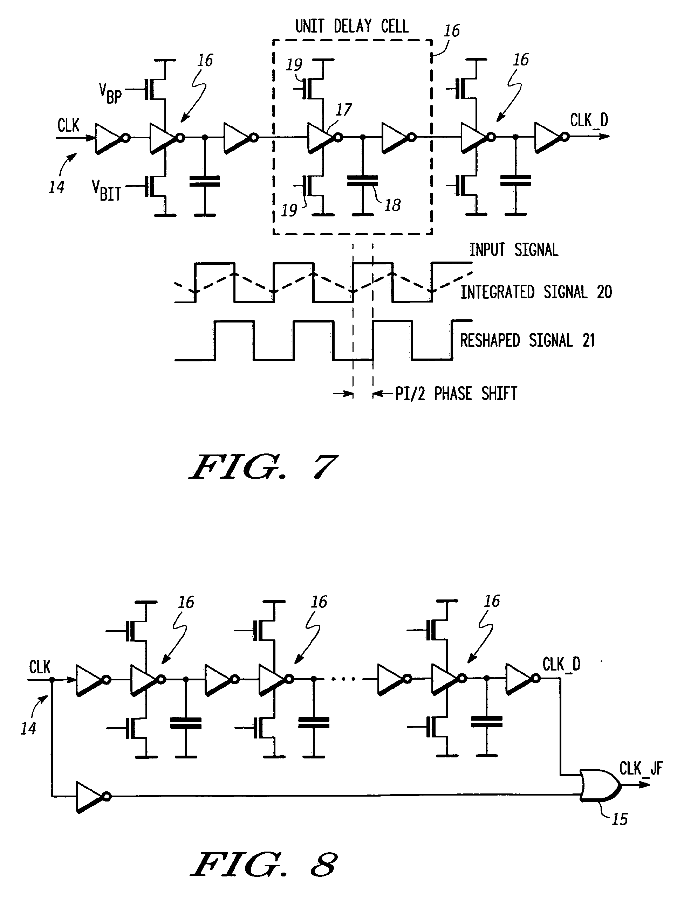

A simple practical implementation of the delay line 14 in a SOC environment is shown in Figure 7 and comprises a series of unit delay cells 16 each having an RC (resistor, capacitor) or IC (current, capacitor) time constant. The IC time constant shown in Figure 7 is obtained using a current starved inverter 17 that charges a capacitor 18. The gates of transistors 19 that starve the inverter are biased using current mirrors (not shown). The biasing current can be generated in such a way it is proportional to a resistor in order to make the cell's time constant proportional to a resistor-capacitor product (RC).

In this embodiment of the invention, the biasing current is generated by a tuning circuit in order to make the cell's delay process and temperature variation independent. In each unit cell a high gain and fast buffer is used to reshape the slow transitions of the output signal (integrated signal 20) of the current-starved inverter into a square wave signal (reshaped signal 21). A delay of exactly two thirds of the clock period is obtained by using three delay cells that contribute each 90° phase shift. The 90° phase shift is obtained by making each cell time constant many times larger than the clock period in such a way the cell voltage saturation is never attained.

With such a delay line it is important to control the delayed signal duty cycle. In fact, each cell's common mode voltage depends on the initial conditions which may make the signal duty cycle unpredictable. It would be possible to make the unit cell's duty-cycle constant (at say 50%) by using a feedback loop that detects the duty-cycle error and compensate for it. However, this method requires very large time constants to filter out the high frequency content of a square wave and extract its DC value (duty cycle is proportional to DC value).

In the delay line shown in Figure 7, the delayed signal duty-cycle is controlled using unit cells that have time constants small enough to reach saturation and settling within one half of a clock period. In this signal configuration, whatever the initial condition is, the integrated signal reaches saturation early enough to allow full settling to one of the power supply rails. As the signal transitions from one power supply rail to another, the duty-cycle is constant, predictable and completely independent of the initial conditions. However, the signal delay obtained with one unit delay cell is much smaller than in the previous case. Thus, to achieve 2/3 of a clock period delay it is necessary to cascade many (more than 3) unit delay cells as it is shown in Figure 8 that illustrates a complete jitter attenuator circuit.

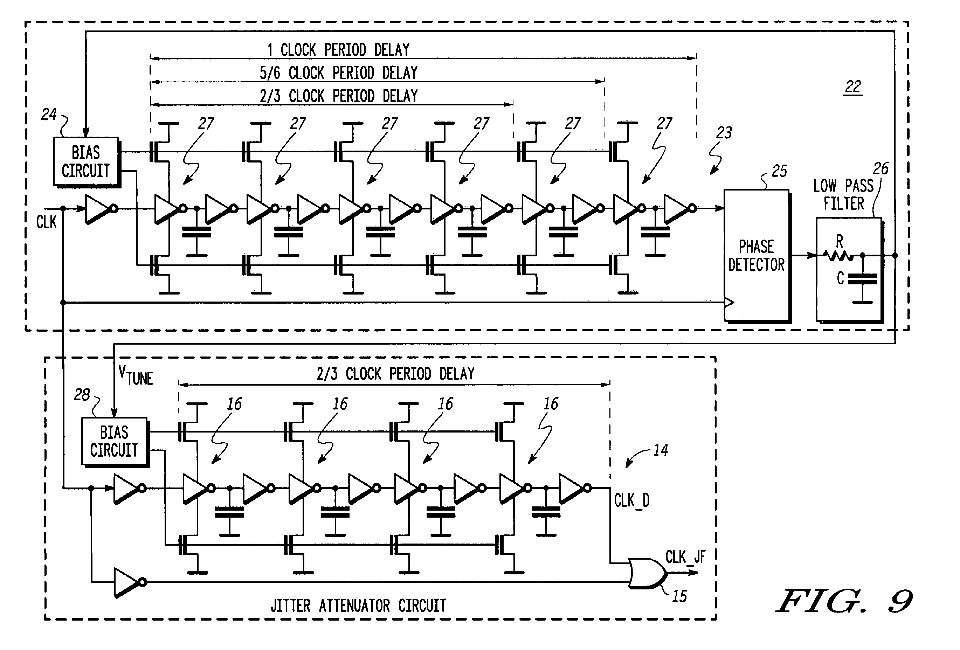

Delay lines of the SOC kind tend to suffer from process and temperature dependence of their characteristics. This in turn makes the gain of the sigma delta converter (either analog to digital or digital to analog) sensitive to temperature and process variations. An embodiment of the invention that has reduced sensitivity to process variation using some additional circuitry is shown in Figure 9.

The clock pulse generator shown in Figure 9 includes a Delay Lock Loop (DLL) 22 to tune the delay line. The DLL tuning circuit 22 works as following. A clock signal CLK, in this case the same as the sigma delta sampling clock, is delayed by a delay line 23 similar in structure to the delay line 14 of the jitter attenuator but with a delay long enough to cover a complete clock period. The delay is tunable through a biasing circuit 24 that acts on the current flowing on each unit delay cell. The delayed and non-delayed clock signals are phase-locked using a phase detector 25 that drives a low pass filter 26 whose output Vtune is used to control the current from the biasing circuit 24 and tune the delay line. In such a manner, the loop adjusts progressively the delay in the delay line towards one clock period delay at which full phase lock is achieved. Hence, whatever the process and temperature variation the loop ensures that the delay in the delay line is exactly one clock period that is very temperature-stable as it is generated using a crystal oscillator.

In this embodiment of the invention, the delay line 23 of the DLL 22 uses 6 unit delay cells 27, similar to the cells 16, that each contribute a delay of one sixth of the clock period. The same tuning voltage out of the DLL (Vtune) is used to tune the delay line 14 of the jitter attenuator as well, through a biasing circuit 28, similar to the biasing circuit 24 of the DLL. This latter is constituted of four cascaded delay elements. Consequently, it contributes a delay that is two thirds of the clock period and that is constant over process and temperature variations, since it is ensured that the delay cell elements 16 of the jitter attenuator are well matched to the delay cell elements 27 of the DLL.

In order to avoid the DLL injecting low frequency jitter in the reference delay line through the Vtune signal a very low cut-off frequency of the low pass filter 26 is implemented. If necessary, an external capacitor is used, especially when very low frequency jitter needs to be suppressed. However, it has been found that typically, in high speed SOCs, high frequency jitter is dominant. Suppression of these high frequency jitter components does not require an external DLL loop filter capacitor.

It will be appreciated that the clock pulse generator with a substantially jitter-free active phase enables the associated circuits driven by the clock pulse generator to function with little or no sensitivity to clock pulse jitter. Unlike previous approaches that modify the original topology of the associated circuit to make it resistant to jitter, this technique does not interfere at all with the associated circuit. It has a particular advantage in that it applies to both sigma delta ADCs and DACs. In particular, the clock pulse generator with a substantially jitter-free active phase enables continuous time sigma deltas to be integrated into System-On-Chips. It also allows their integration in other environments where high cost, low noise PLLs are not available.

**Claims**

1. Clock pulse generator apparatus comprising a clock pulse generator (CLK) for generating a train of primary clock pulses having leading and trailing edges, **characterised by** delay means (14) for producing a train of delayed clock pulses (CLK_D) presenting delayed edges whose timing relative to corresponding edges of said primary clock pulses (CLK) is defined by said delay means, and combining means (15) for producing a train of combined clock pulses (CLK_JF) presenting leading and trailing edges defined alternately by one of said delayed edges and the corresponding edge of the primary clock pulse, so that said combined clock pulses comprise active clock phases (ACP) having widths defined by said delay means, the variability of said widths of said active clock phases (ACP) being smaller than the variability of the positions of said leading and trailing edges of said primary clock pulses (CLK).

2. Clock pulse generator apparatus as claimed in claim 1, wherein said active clock phases (ACP) are arranged to alternate with non-active clock phases (NACP) whose widths vary as a function of variation in the positions of said primary clock pulses (CLK).

3. Clock pulse generator apparatus as claimed in claim 12 wherein said delay means (14) comprises a series of cascaded, substantially identical delay elements (16).

4. Clock pulse generator apparatus as claimed in claim 3 wherein said delay means (14) comprises a further series (22) of cascaded delay elements (27) substantially identical to the first said delay elements (16), adjustment means (24, 25, 26) responsive to the delay of said further series (22) relative to a pulse period of said train of primary clock pulses (CLK) for applying an adjustment signal ($V_{tune}$) to tend to correct the delay of said further series (22) of delay elements relative to a pulse period, said adjustment signal being averaged over a plurality of clock periods, and means for applying said adjustment signal ($V_{tune}$) to adjust the delay of the delay elements (16) of said first series (14).

5. Clock pulse generator apparatus as claimed in claim 3 or 4 wherein each of said delay elements (16; 27) comprises a respective capacitive element (18), current supply means (17, 19) responsive to an signal input to the delay element for supplying a controlled current to said respective capacitive element, and trigger means responsive to the voltage (20) at said respective capacitive element (18).

6. Apparatus for converting between analogue and digital signals comprising continuous-time sigma-delta conversion means and clock pulse generator apparatus as claimed in any preceding claim.

7. Apparatus for converting between analogue and digital signals as claimed in claim 6, wherein said continuous-time sigma-delta conversion means comprises integration means (2; 10) for integrating a signal (Input) over periods of time defined by said widths of said active clock phases (ACP).

8. Apparatus for converting between analogue and digital signals as claimed in claim 7, wherein said continuous-time sigma-delta conversion means comprises digital-to-analogue converter means (5; 9) whose operation is responsive to said train of combined clock pulses (CLK_JF).

9. Apparatus for converting an analogue signal to a digital signal in accordance with claim 8, wherein said continuous-time sigma-delta conversion means comprises an input for receiving said analogue signal (Input) and an output for said digital signal and a feedback loop from said output including said digital-to-analogue converter means (5).

10. Apparatus for converting a digital signal to an analogue signal in accordance with claim 8, wherein said continuous-time sigma-delta conversion means comprises an input for receiving said digital signal (Input) and an output for said analogue signal ($V_{out}$), said digital-to-analogue converter means (9) being in series between said input and said output.

*FIG. 1*

*FIG. 2*

*FIG. 3*

FIG. 4

FIG. 5

FIG. 6

UNIT DELAY CELL

INPUT SIGNAL

INTEGRATED SIGNAL 20

RESHAPED SIGNAL 21

PI/2 PHASE SHIFT

## FIG. 7

## FIG. 8

FIG. 9

**European Patent Office**

# EUROPEAN SEARCH REPORT

Application Number

EP 03 29 2967

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 2002/186064 A1 (OOISHI TSUKASA) 12 December 2002 (2002-12-12) | 1-3,5-10 | H03K5/13 |
| Y | * paragraphs [0005] - [0013] * <br> * paragraphs [0225] - [0234] * <br> * figures 30,31,55 * | 4 | |
| Y | WO 02/095943 A (ATYUNIN VASILY GRIGORIEVICH) 28 November 2002 (2002-11-28) | 4 | |
| A | * page 4, line 18 - page 8, line 3; figures 1,2 * | 1-3,5-10 | |
| A | US 6 373 313 B1 (HISHIYAMA HIROYUKI) 16 April 2002 (2002-04-16) * column 5, line 56 - column 6, line 19; figures 4,5a,5b * | 1-10 | |
| A | US 2002/140590 A1 (ESHRAGHI ARIA ET AL) 3 October 2002 (2002-10-03) * paragraphs [0003], [0004], [0020] - [0027]; figures 1,3 * | 1-10 | |
| | | | TECHNICAL FIELDS SEARCHED (Int.Cl.7) |
| A | GERFERS F ET AL: "A 1.5-V 12-BIT POWER-EFFICIENT CONTINUOUS-TIME THIRD-ORDER SIGMADELTA MODULATOR" IEEE JOURNAL OF SOLID-STATE CIRCUITS, IEEE INC. NEW YORK, US, vol. 38, no. 8, August 2003 (2003-08), pages 1343-1352, XP001170974 ISSN: 0018-9200 * page 1343; figure 1 * | 1-10 | H03K |

The present search report has been drawn up for all claims

| Place of search | Date of completion of the search | Examiner |
|---|---|---|
| The Hague | 7 May 2004 | Meulemans, B |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**ANNEX TO THE EUROPEAN SEARCH REPORT
ON EUROPEAN PATENT APPLICATION NO.**

EP 03 29 2967

This annex lists the patent family members relating to the patent documents cited in the above-mentioned European search report.
The members are as contained in the European Patent Office EDP file on
The European Patent Office is in no way liable for these particulars which are merely given for the purpose of information.

07-05-2004

| Patent document cited in search report | | Publication date | Patent family member(s) | | Publication date |
|---|---|---|---|---|---|
| US 2002186064 | A1 | 12-12-2002 | JP<br>US | 2001339283 A<br>2001045856 A1 | 07-12-2001<br>29-11-2001 |
| WO 02095943 | A | 28-11-2002 | EP<br>WO<br>US | 1410504 A2<br>02095943 A2<br>2002196061 A1 | 21-04-2004<br>28-11-2002<br>26-12-2002 |
| US 6373313 | B1 | 16-04-2002 | JP<br>JP | 3456525 B2<br>2000332584 A | 14-10-2003<br>30-11-2000 |
| US 2002140590 | A1 | 03-10-2002 | NONE | | |

EPO FORM P0459

For more details about this annex : see Official Journal of the European Patent Office, No. 12/82